(19)

Europäisches
Patentamt
European
Patent Office
Office européen
des brevets

(11) **EP 2 408 025 A1**

(12) **EUROPEAN PATENT APPLICATION**
published in accordance with Art. 153(4) EPC

(43) Date of publication:
**18.01.2012 Bulletin 2012/03**

(51) Int Cl.:
***H01L 33/00*** (2010.01)

(21) Application number: **10809127.3**

(22) Date of filing: **30.12.2010**

(86) International application number:
**PCT/CN2010/080493**

(87) International publication number:
**WO 2011/143918 (24.11.2011 Gazette 2011/47)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **03.11.2010 CN 201010530991**

(71) Applicant: **Enraytek Optoelectronics Co., Ltd.
Shanghai 201203 (CN)**

(72) Inventors:
• **CHANG, Richard Rugin
Pudong New Area,
Shanghai 21203 (CN)**
• **XIAO, Deyuan
Pudong New Area,
Shanghai 21203 (CN)**

(74) Representative: **Viering, Jentschura & Partner
Grillparzerstrasse 14
81675 München (DE)**

(54) **LIGHT EMITTING DIODE AND MANUFACTURING METHOD THEREOF**

(57) The present invention discloses light emitting diode and fabrication method thereof. The LED comprises: a substrate; an epitaxial layer, an active layer and a capping layer arranged on the substrate in sequence; wherein a plurality of microlens structures are formed on the surface of the substrate away from the epitaxial layer, and a plurality of cams are formed on the surfaces of the microlens structures. When the light emitted from the active layer passes through the surfaces of the microlens structures or the surfaces of the cams, the incident angle is always smaller than the critical angle of total reflection, thus preventing total reflection and making sure that most of the light pass through the surfaces of the microlens structures and the cams, in this way improving external quantum efficiency of the LED, avoiding the rise of the internal temperature of the LED and improving the performance of the LED.

FIG. 2

**EP 2 408 025 A1**

Printed by Jouve, 75001 PARIS (FR)

**Description**

Technical Field

The present invention relates to the light emitting field, and more especially, to a light emitting diode and its fabrication method.

Background Art

Light Emitting Diode (LED), having the advantages of long service life, low energy consumption and others, is widely used in various fields. In particular, with the greatly improved lighting performance, LED is often used as a light emitting device in lighting field. Wherein, the group III-V compound semiconductors such as gallium nitride (GaN), has tremendous application potential in high-brightness blue LED, blue laser and other photoelectric devices due to its wide band gap, high light emitting efficiency, high electronic saturation drift velocity, stable chemical property and other characteristics, which has aroused wide attention.

However, those semiconductor LEDs in the prior art have the problem of low light emitting efficiency. For a conventional LED without packaging, the light extraction efficiency is generally several percent, because a large amount of energy gathers in the device and fails to give out, thus causing energy waste and also affecting the service life of the device. Therefore, to improve the light extraction efficiency of a semiconductor LED is of vital importance.

Based on the abovementioned application demands, many methods for increasing the light extraction efficiency of an LED are applied to the devices, for instance: surface roughening and metal reflector structures.

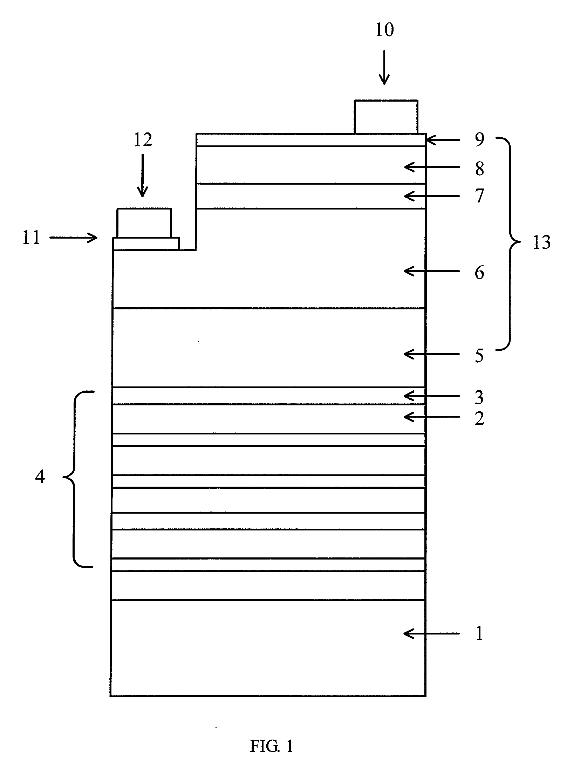

CN 1858918A discloses a GaN-based LED with an omnidirectional reflector structure and its fabrication method. According to FIG. 1, the LED comprises: a substrate 1, an omnidirectional reflector 4 grown on the substrate 1, and a GaN LED chip 13 fabricated on the omnidirectional reflector 4. The GaN LED chip 13 includes: a sapphire substrate 5, an N type GaN layer 6, an active region quantum well layer 7, a P type GaN layer 8, a P type electrode 9, a P type soldering pad 10, an N type electrode 11, and an N type soldering pad 12; wherein the omnidirectional reflector 4 grown on the substrate 1 is stacked by high refractive index layers 3 and low refractive index layers 2, the high refractive index layer 3 is in contact with the sapphire substrate 5, the low refractive index layer 2 is in contact with the substrate 1, the refractive index of the high refractive index layer nH > the refractive index of the low refractive index layer nL > the refractive index of the sapphire material n, and satisfies the formula of $\sin^{-1}\dfrac{n}{nH} < \tan^{-1}\dfrac{nL}{nH}$ , where-

in n, nH and nL represent refractive index. This patent forms an omnidirectional reflector structure on the bottom surface of the LED chip to reflect the light emitted by GaN material at a high refractive index upwards within the omnidirectional range so as to improve the light extraction efficiency of the LED. However, the fabrication process of the LED requires the forming of a film structure stacked by multiple high refractive index layers and low refractive index layers on the substrate, which is a complicated technique and is unfavourable to put into application.

Summary of the Invention

The present invention aims at providing a light emitting diode to solve the problem of low light extraction efficiency of the traditional light emitting diodes.

Another purpose of the present invention is to provide a fabrication method of light emitting diode with simple process and improves the light extraction efficiency of light emitting diodes.

To solve the abovementioned technical problems, the present invention provides a light emitting diode, the light emitting diode comprises: a substrate; an epitaxial layer, an active layer and a capping layer arranged on the substrate in sequence; wherein, a plurality of microlens structures are formed on the surface of the substrate away from the epitaxial layer, and a plurality of cams are formed on the surfaces of the microlens structures and on the surface of the substrate away from the epitaxial layer.

Furthermore, the substrate is a sapphire substrate, a silicon carbide substrate or a gallium nitride substrate.

Furthermore, the light emitting diode further comprises a buffer layer between the substrate and the epitaxial layer and a transparent conductive layer on the capping layer.

Furthermore, the light emitting diode further comprises a first electrode, a second electrode, and an opening passing through the transparent conductive layer, the capping layer and the active layer, wherein, the first electrode is on the transparent conductive layer to connect the transparent conductive layer to the positive terminal of a power; the second electrode is in the opening to connect the epitaxial layer to the negative terminal of the power.

Furthermore, the light emitting diode further comprises a passivation layer on the transparent conductive layer; the passivation layer covers the first electrode and the second electrode.

Furthermore, the material of the epitaxial layer is N-doped gallium nitride; the active layer comprises a multiple-quantum-well active layer, the material of the multiple-quantum-well active layer is indium-gallium nitride; the material of the capping layer is P-doped gallium nitride.

Correspondingly, the present invention further provides a fabrication method of light emitting diode, which comprises: providing a substrate; forming an epitaxial layer, an active layer and a capping layer on the substrate in sequence; forming a plurality of microlens structures on the surface of the substrate away from the epitaxial layer, and forming a plurality of cams on the surfaces of the microlens structures and on the surface of the substrate away from the epitaxial layer.

Furthermore, in the fabrication method of light emitting diode, the step of forming a plurality of microlens structures and a plurality of cams comprises: forming a plurality of cylindrical photoresist blocks on the surface of the substrate away from the epitaxial layer; baking the cylindrical photoresist blocks to turn the cylindrical photoresist blocks into spherical-crown photoresists; performing a first inductive coupled plasma etch process until the spherical-crown photoresists are completely etched so as to form a plurality of microlens structures on the surface of the substrate away from the epitaxial layer; forming a plurality of $Al_2O_3$ particles on the surface of the substrate away from the epitaxial layer and on the surfaces of the microlens structures; performing a second inductive coupled plasma etch process until the $Al_2O_3$ particles are completely etched so as to form a plurality of cams on the surface of the substrate away from the epitaxial layer and on the surfaces of the microlens structures.

Furthermore, in the fabrication method of light emitting diode, in the first inductive coupled plasma etch process, the etching gas is a mixture of boron trichloride, helium gas and argon gas, the cavity pressure is 50mTorr~2Torr, the plate power is 200W~300W, the coil power is 300W~500W.

Furthermore, in the fabrication method of light emitting diode, in the second inductive coupled plasma etch process, the etching gas is a mixture of boron trichloride, helium gas and argon gas, the cavity pressure is 50mTorr~2Torr, the plate power is 200W~300W, the coil power is 300W~500W.

Furthermore, in the fabrication method of light emitting diode, the cylindrical photoresist blocks are baked under a temperature of 120 °C ~250°C to turn the cylindrical photoresist blocks into spherical-crown photoresists.

Furthermore, in the fabrication method of light emitting diode, the material of the epitaxial layer is N-doped gallium nitride; the active layer comprises a multiple-quantum-well active layer, the material of the multiple-quantum-well active layer is indium-gallium nitride; the material of the capping layer is P-doped gallium nitride.

Furthermore, in the fabrication method of light emitting diode, before the formation of the epitaxial layer, further comprises: growing a gallium nitride film on the substrate to form a buffer layer.

Furthermore, in the fabrication method of light emitting diode, after the formation of the capping layer, further comprises: forming a transparent conductive layer on the capping layer.

Furthermore, in the fabrication method of light emitting diode, after the formation of the transparent conductive layer, further comprises: forming a first electrode on the transparent conductive layer; forming an opening passing through the transparent conductive layer, the capping layer and the active layer; forming a second electrode in the opening.

Furthermore, in the fabrication method of light emitting diode, after forming the second electrode in the opening, further comprises: forming a passivation layer on the transparent conductive layer, the passivation layer covers the first electrode and the second electrode.

Furthermore, in the fabrication method of light emitting diode, before the formation of a plurality of microlens structures on the surface of the substrate away from the epitaxial layer, further comprises: reducing the thickness of the substrate.

With the adoption of the technical solution above, compared with the prior art, the present invention has the following advantages:

The substrate of the LED has a plurality of microlens structures on the surface away from the epitaxial layer, and there are a plurality of cams on the surfaces of the microlens structures and on the surface of the substrate away from the epitaxial layer. When the light from the active layer passes through the surfaces of the microlens structures or the surfaces of the cams, the incident angle is always smaller than the critical angle of total reflection so as to prevent total reflection and make sure most of the light pass through the surfaces of the microlens structures or the surfaces of the cams, in this way improving the external quantum efficiency of the LED, increasing the light extraction efficiency of the LED, avoiding the rising of the internal temperature of the LED and improving the performance of the LED.

Brief Description of the Drawings

FIG. 1 is a schematic view of the LED in the prior art;
FIG. 2 is a schematic view of the LED according to one embodiment of the present invention;
FIG. 3 is a flow chart of the fabrication method of LED according to one embodiment of the present invention;
FIG. 4A~4K are sectional views of the fabrication method of LED according to one embodiment of the present invention;
FIG. 5 is a top view of the cylindrical photoresist blocks according to one embodiment of the present invention.

Detailed Description of Preferred Embodiments

To make the abovementioned purposes, features and merits of the present invention clearer and easier to understand, the present invention is further detailed by embodiments in combination with the drawings.

The core spirit of the present invention is to provide an LED and its fabrication method, wherein the substrate of the LED has a plurality of microlens structures on the surface away from the epitaxial layer, and there are a plurality of cams on the surfaces of the microlens structures and on the surface of the substrate away from the epitaxial layer. When the light emitted from the active layer passes through the surfaces of the microlens structures or the surfaces of the cams, the incident angle is always smaller than the critical angle of total reflection so as to prevent total reflection and make sure most of the light pass through the surfaces of the microlens structures or the surfaces of the cams, in this way improving the external quantum efficiency of the LED, increasing the light extraction efficiency of the LED, avoiding the rising of the internal temperature of the LED and improving the performance of the LED.

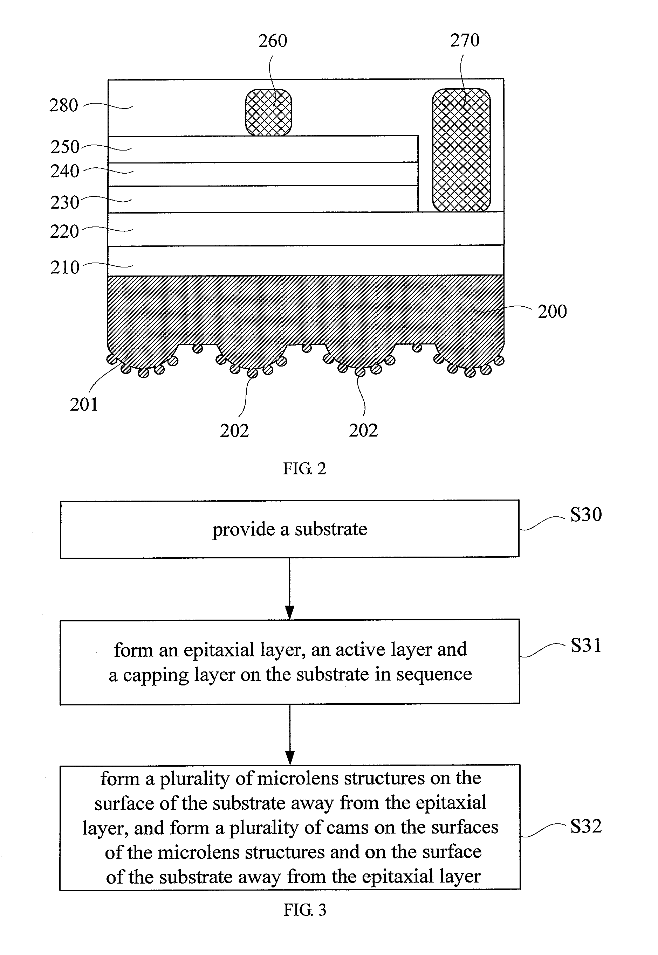

FIG. 2 shows a schematic view of the light emitting diode (LED) according to one embodiment of the present invention. The LED is a light emitting diode with sapphire as the substrate. The LED is a gallium nitride (GaN)-based LED. As shown in FIG. 2, the LED comprises: a substrate 200 as well as an epitaxial layer 220, an active layer 230 and a capping layer 240 arranged on the substrate 200 in sequence, wherein the substrate 200 of the LED has a plurality of microlens structures 201 on the surface away from the epitaxial layer 220, and there are a plurality of cams 202 on the surfaces of the microlens structures 201 and on the surface of the substrate 200 away from the epitaxial layer 220. When the light emitted from the active layer 230 passes through the surfaces of the microlens structures 201 or the surfaces of the cams 202, the incident angle is always smaller than the critical angle of total reflection so as to prevent total reflection and make sure most of the light pass through the surfaces of the microlens structures 201 or the surfaces of the cams 202, in this way improving external quantum efficiency of the LED, avoiding the rise of the internal temperature of the LED and improving the performance of the LED.

In this embodiment, sapphire is selected to be the substrate 200. It shall be known that the substrate 200 can also be made of silicon carbide or gallium nitride.

Furthermore, the LED further comprises a buffer layer 210 which is between the substrate 200 and the epitaxial layer 220 (namely, the surface of the substrate 200 near the epitaxial layer 220 is in contact with the buffer layer 210), wherein the buffer layer 210 can further solve the problem of lattice constant mismatch between the substrate 200 and gallium nitride material. The buffer layer 210 generally adopts gallium nitride film grown under low temperature.

The epitaxial layer 220, the active layer 230 and the capping layer 240 are arranged on the substrate 200 in sequence, wherein the epitaxial layer 220, the active layer 230 and the capping layer 240 form the tube core of the LED. The epitaxial layer 220 is made of N-doped gallium nitride (n-GaN); the active layer 230 includes a multiple-quantum-well active layer, wherein the multiple-quantum -well active layer is made of indium-gallium nitride (InGaN) to emit blue light with wave length of 470nm; the capping layer 240 is made of P-doped gallium nitride (p-GaN). Since the epitaxial layer 220 and the capping layer 240 are oppositely doped, the N-doped gallium nitride is driven by an external voltage to make electrons drift, while the P-doped gallium nitride is driven by the external voltage to make holes drift, the holes and the electrons are mutually combined in the multiple-quantum-well active layer (also known as active layer) so as to emit light.

Furthermore, the LED further comprises a transparent conductive layer (TCL) 250, wherein the transparent conductive layer 250 is on the capping layer 240. Since the P-doped gallium nitride has a low electric conductivity, a current spreading metal layer, namely the transparent conductive layer 250, is deposited on the surface of the capping layer 240 to raise the electric conductivity. Wherein, the transparent conductive layer 250 can be made of such materials as nickel/gold (Ni/Au).

In addition, since the substrate 200 does not conduct electricity, in order to connect the tube core of the LED to the positive and negative terminals of the power, the LED further comprises a first electrode 260, a second electrode 270, and an opening passing through the transparent conductive layer 250, the capping layer 240 and the active layer 230; wherein the first electrode 260 is on the transparent conductive layer 250 to connect the transparent conductive layer 250 to the positive terminal of the power; the second electrode 270 is in the opening to connect the epitaxial layer 220 to the negative terminal of the power.

When the LED is used for light emitting, the first electrode 260 is connected to the positive terminal of the power, the second electrode 270 is connected to the negative terminal of the power, the tube core of the LED is connected to the positive terminal of the power via the first electrode 260, and is connected to the negative terminal of the power via the second electrode 270. The active layer 230 in the tube core of the LED emits light under force of current, the microlens structures 201 make sure that most of the light pass through the surfaces of the microlens structures 201, in this way improving external quantum efficiency of the LED, avoiding the rise of the internal temperature of the LED and improving the performance of the LED.

Furthermore, the LED further comprises a passivation layer 280 on the transparent conductive layer 250, wherein the passivation layer 280 covers the first electrode 260, the second electrode 270 and the transparent conductive layer 250, and is filled into the opening, to protect the tube core of the LED from damage.

Correspondingly, the present invention further provides a fabrication method of LED, as shown in FIG. 3, which is a flow chart of the fabrication method of LED according to one embodiment of the present invention.

The fabrication method of LED comprises the following steps:

S30, provide a substrate;

S31, form an epitaxial layer, an active layer and a capping layer on the substrate in sequence;

S32, form a plurality of microlens structures on the surface of the substrate away from the epitaxial layer, and form a plurality of cams on the surfaces of the microlens structures and on the surface of the substrate away from the epitaxial layer.

The fabrication method of LED of the present invention will be further detailed in combination with the sectional views, which show a preferred embodiment of the present invention. It shall be understood that those skilled in the art may make changes while still realize the favorable effects of the invention based on this description. Therefore, the description below shall be understood as widely known by those skilled in the art rather than the limitation to the present invention.

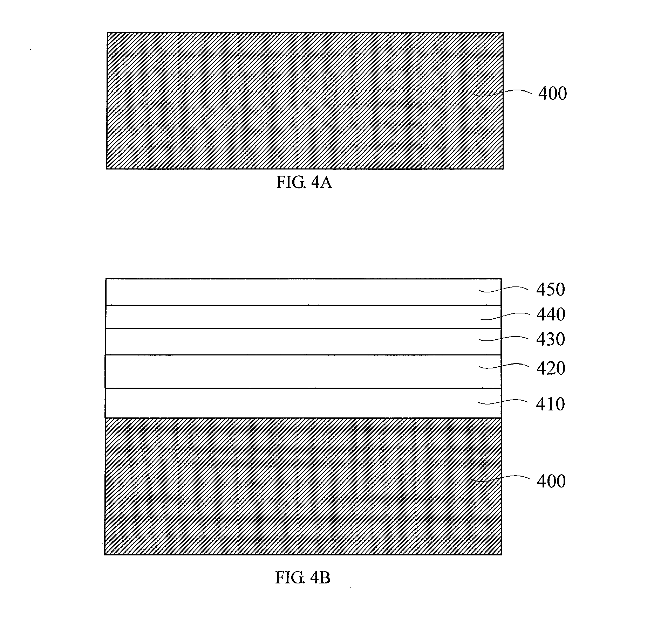

Refer to FIG. 4A, firstly provide a substrate 400, wherein the substrate 400 is made of $Al_2O_3$. According to this embodiment, the substrate 400 is used to form a gallium nitride based blue LED.

Refer to FIG. 4B, in order to solve the problem of lattice constant mismatch between the substrate 400 and gallium nitride material, then, form a buffer layer 410 on the substrate 400, wherein the buffer layer 410 generally adopts gallium nitride film grown under low temperature.

Further refer to FIG. 4B, after the formation of the buffer layer 410, form an epitaxial layer 420, an active layer 430 and a capping layer 440 on the buffer layer 410 in sequence, wherein the epitaxial layer 420, the active layer 430 and the capping layer 440 constitute the tube core of the LED. The epitaxial layer 420 is made of N-doped gallium nitride; the active layer 430 includes a multiple-quantum-well active layer, wherein the multiple-quantum-well active layer is made of indium-gallium nitride; the capping layer 440 is made of P-doped gallium nitride.

Further refer to FIG. 4B, after the formation of the capping layer 440, form a transparent conductive layer 450 on the capping layer 440. The transparent conductive layer 450 is used to raise the electric conductivity. The transparent conductive layer 450 can be made of Ni/Au. The buffer layer 410, the epitaxial layer 420, the active layer 430 and the capping layer 440 can be formed by means of conventional metal organic chemical vapor deposition (MOCVD) process; the transparent conductive layer 450 can be formed by means of physical vapor deposition (PVD) process.

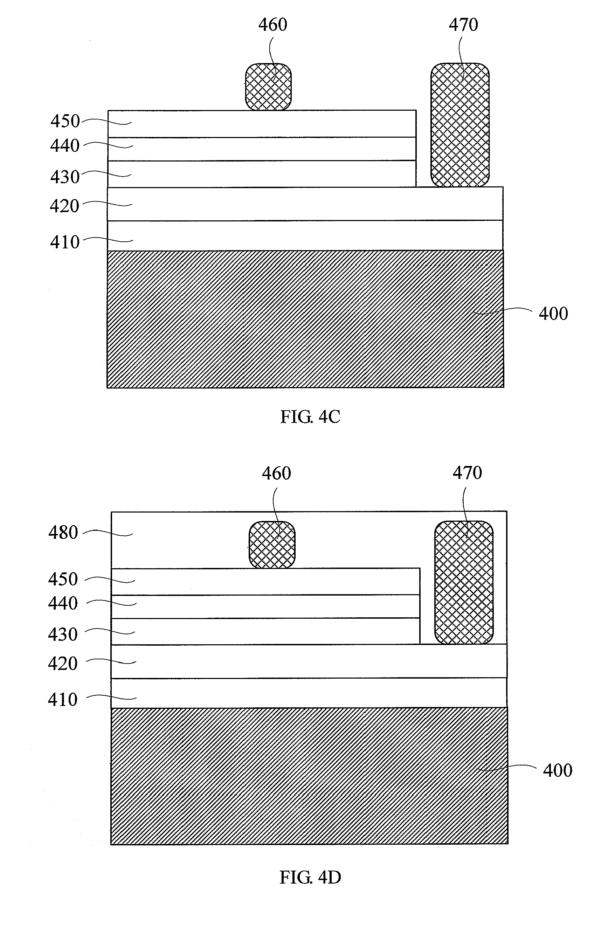

Refer to FIG. 4C, afterwards, form a first electrode 460 on the transparent conductive layer 450 to connect the transparent conductive layer 450 to the positive terminal of the power; and then form an opening passing through the transparent conductive layer 450, the capping layer 440 and the active layer 430 by means of photolithography and etch, after that, form a second electrode 470 in the opening to connect the epitaxial layer 420 to the negative terminal of the power. Preferably, the upper surfaces of the first electrode 460 and the second electrode 470 are on the same level. In other embodiments, the opening can also be extended into the epitaxial layer 420, in other words, the opening can also pass through part of the thickness of the epitaxial layer 420.

Refer to FIG. 4D, next, form a passivation layer 480 on the transparent conductive layer 450, wherein the passivation layer 480 covers the transparent conductive layer 450, the first electrode 460 and the second electrode 470, and is filled into the opening. The passivation layer 480 is used to protect the tube core of the LED from damage.

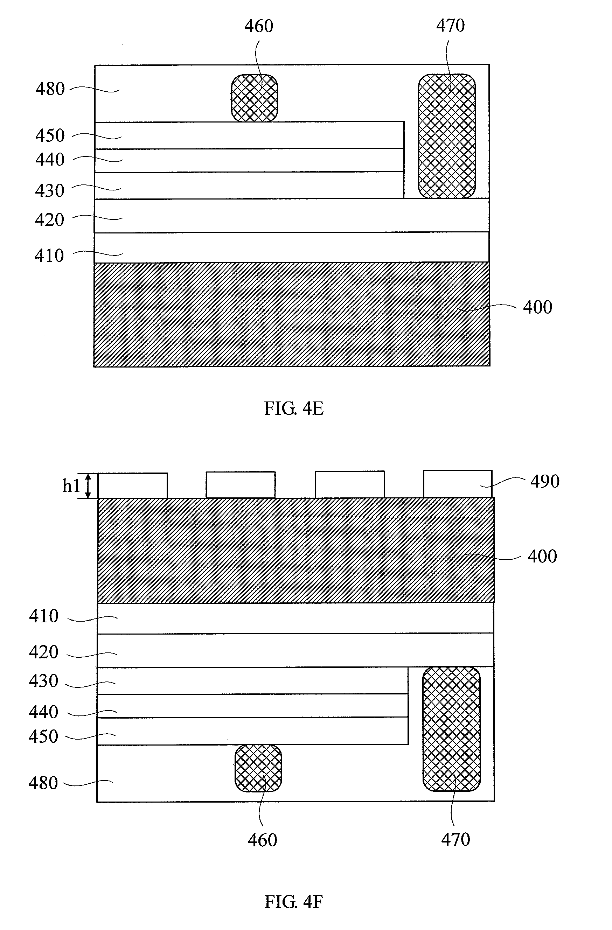

Refer to FIG. 4E, afterwards, reduce the thickness of the substrate 400. The thinning of the substrate 400 can be realized by backside grinding or laser liftoff (LTO) process. In this embodiment, the substrate 400 is thinned to $10{\sim}100\mu m$.

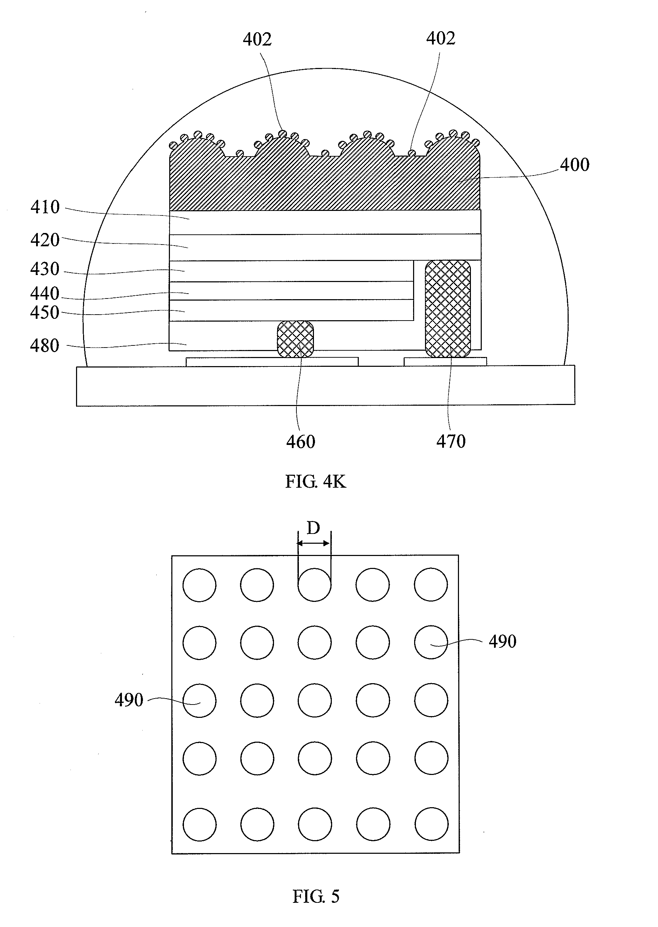

Refer to FIG. 4F, next, turn over the substrate 400 after thinning to bring the side of the substrate 400 away from the epitaxial layer 420 (the side without contacting the buffer layer 410) upward, and then form a plurality of cylindrical photoresist blocks 490 arranged in array on the substrate 400 by photoresist coating, exposing and developing processes. Refer to FIG. 5, the vertical view (parallel to the surface of the substrate 400) of the cylindrical photoresist blocks 490 are round-shaped. Alternatively, the cylindrical photoresist blocks 490 have a thickness h1 of $0.1\mu m{\sim}5\mu m$ and a diameter D of $1\mu m{\sim}10\mu m$, and the spacing between adjacent blocks 490 is $0.1\mu m{\sim}1\mu m$. It shall be understood that those skilled in the art may adjust the dimensions of the cylindrical photoresist blocks 490 according to the desired size of the microlens structures.

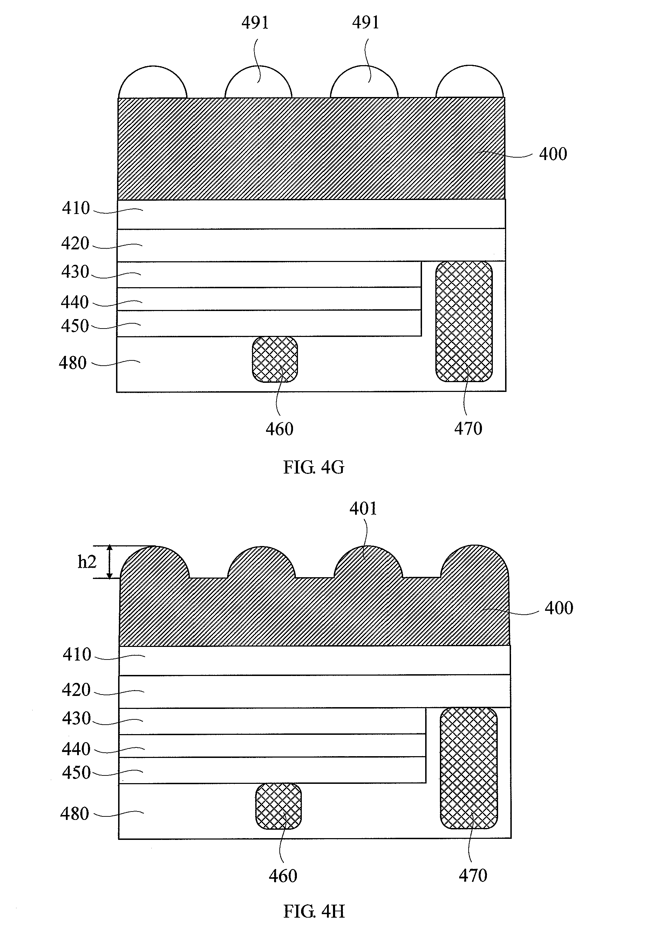

Refer to FIG. 4G. afterwards, bake the cylindrical photoresist blocks 490 to turn the cylindrical photoresist blocks 490 into spherical-crown photoresists 491. In this embodiment, the cylindrical photoresist blocks 490 are baked under the temperature of 120 °C ~250 °C The cylindrical photoresist blocks 490 become spherical-crown photoresists 491 under force of surface tension at a temperature higher than the glass melting temperature of the photoresist. In other embodiments, the cylindrical photoresist blocks 490 can also be baked under other temperatures.

Refer to FIG. 4H, next, perform a first inductive coupled plasma (ICP) etch process by using the spherical-crown photoresists 491 as mask until the spherical-crown photoresists 491 are completely etched so as to form a plurality of microlens structures 401 on the surface of the substrate 400 away from the epitaxial layer 420. Wherein, the height h2 of the microlens structures 401 can be $3\mu m{\sim}5\mu m$. It is acceptable to adjust the height of the microlens structures 401 according to the requirements of the corresponding devices.

Alternatively, in the first inductive coupled plasma etch process, the etching gas can be a mixture of boron trichloride ($BCl_3$), helium gas (He) and argon gas (Ar), wherein the flow rate of boron trichloride can be, for example, 20~1000sccm; the flow rate of helium gas can be, for example, 20~500sccm; the flow rate of argon gas can be, for example, 20~500sccm; the cavity pressure is 50mTorr~2Torr, the plate power is 200W~300W and the coil power is 300W~500W.

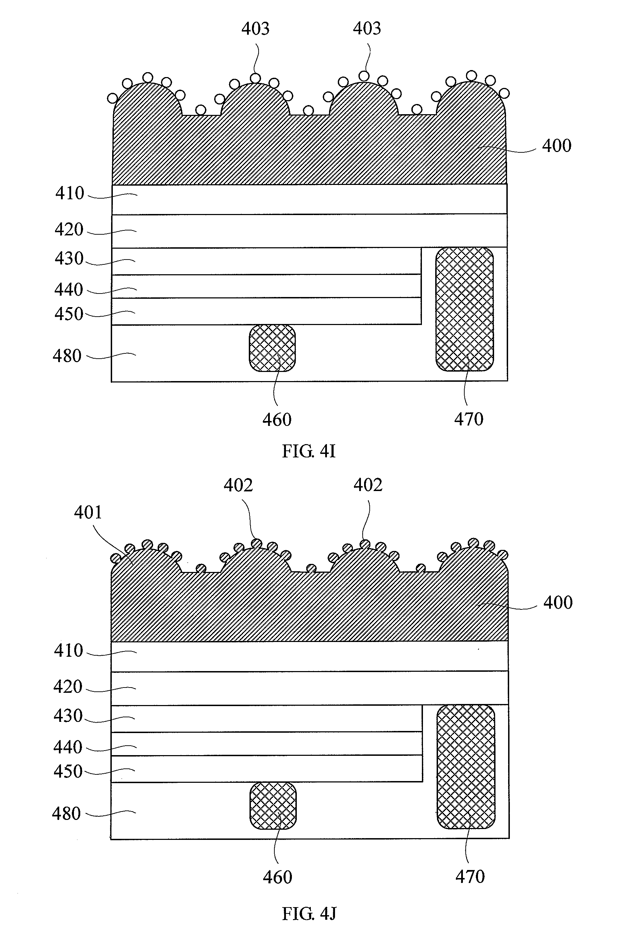

Refer to FIG. 4I, afterwards, form a plurality of $Al_2O_3$ particles 403 on the surface of the substrate 400 away from the epitaxial layer 420 and on the surfaces of the microlens structures 401.

The diameter of the $Al_2O_3$ particles can be 100nm~5$\mu$m. In other embodiments, the size of the $Al_2O_3$ particles can be adjusted according to the cam sizes required. In this embodiment, the $Al_2O_3$ particles 403 can be sprayed to the surface of the substrate 400 away from the epitaxial layer 420 and on the surfaces of the microlens structures 401 by using an electronic shower device (E-shower), and the $Al_2O_3$ particles 403 can be adhered to the substrate 400 by means of electrostatic adherence. However, it shall be known that the present invention is not limited by this. Other materials that can be used as mask, such as polystyrene nanospheres, can be alternatively formed on the surface of the substrate 400 away from the epitaxial layer 420 and on the surfaces of the microlens structures 401.

Refer to FIG. 4J, then perform a second inductive coupled plasma etch process, simultaneously etching the substrate 400 and the $Al_2O_3$ particles 403 until the $Al_2O_3$ particles 403 are completely etched, in this way, a plurality of cams 402 are formed on the surface of the substrate 400 away from the epitaxial layer and on the surfaces of the microlens structures 401.

Alternatively, in the second inductive coupled plasma etch process, the etching gas is the same as in the first inductive coupled plasma etch process, the cavity pressure is kept unchanged, and the plate power and the coil power are also kept unchanged. For instance, the etching gas is a mixture of boron trichloride, helium gas and argon gas, the cavity pressure is 50mTorr~2Torr, the plate power is 200W~300W and the coil power is 300W~500W The etching time of the second inductive coupled plasma etch process can be determined according to the size of the $Al_2O_3$ particles 403, for example, from 10s to 200s.

It shall be noted that the description above does not constitute limitation to the present invention. Those skilled in the art may regulate the etching gas and various technical parameters as well as the etching selection ratio according to the real-life conditions of the etching machine so as to form microlens structures on the substrate.

Refer to FIG. 4K, after the formation of the microlens structures 401 and cams 402, part of the thickness of the passivation layer 480 can be removed by traditional etch back process, and then the LED can be packaged by conventional dicing and bumping packaging process to form LED packages. The present invention does not relate to the improvement of the packaging process, so details are not given herein anymore, but those skilled in the art shall know about this.

It shall be noted that, the blue LED in the abovementioned embodiment is taken as an example, but this does not constitute limitation to the present invention, the above embodiment can also be applied to red LED, yellow LED. Those skilled in the art may make modification, replacement and deformation to the present invention according to the embodiment above.

To sum up, the present invention provides an LED and its fabrication method, wherein the substrate of the LED has a plurality of microlens structures on the surface away from the epitaxial layer, and there are a plurality of cams on the surfaces of the microlens structures and the surface of the substrate away from the epitaxial layer. When the light emitted from the active layer passes through the surfaces of the microlens structures or the surfaces of the cams, the incident angle is always smaller than the critical angle of total reflection so as to prevent total reflection and make sure most of the light pass through the surfaces of the microlens structures or the surfaces of the cams, in this way improving external quantum efficiency of the LED, increasing the light extraction efficiency of the LED, avoiding the rise of the internal temperature of the LED and improving the performance of the LED. Compared with the prior art, the present invention has simpler LED manufacturing process and lower manufacturing cost.

It is clear that those skilled in the art may make various changes and deformations without deviating from the spirit and protection scope of the present invention. If such changes and deformations are within the scope of the claims and the equivalent technological scope, the present invention is also intended to include these changes and deformations.

## Claims

1. A light emitting diode, comprising:

   a substrate;
   an epitaxial layer, an active layer and a capping layer arranged on the substrate in sequence;
   wherein, a plurality of microlens structures are formed on the surface of the substrate away from the epitaxial layer, and a plurality of cams are formed on the surfaces of the microlens structures and on the surface of the substrate away from the epitaxial layer.

2. The light emitting diode as claimed in claim 1, **characterized in that**, the substrate is a sapphire substrate, a silicon carbide substrate or a gallium nitride substrate.

**3.** The light emitting diode as claimed in claim 1, **characterized in that**, the light emitting diode further comprises a buffer layer between the substrate and the epitaxial layer, the material of the buffer layer being gallium nitride.

**4.** The light emitting diode as claimed in claim 1, **characterized in that**, the light emitting diode further comprises a transparent conductive layer on the capping layer.

**5.** The light emitting diode as claimed in claim 4, **characterized in that**, the light emitting diode further comprises a first electrode, a second electrode, and an opening passing through the transparent conductive layer, the capping layer and the active layer, wherein,
the first electrode is on the transparent conductive layer to connect the transparent conductive layer to the positive terminal of a power;
the second electrode is in the opening to connect the epitaxial layer to the negative terminal of the power.

**6.** The light emitting diode as claimed in claim 5, **characterized in that**, the light emitting diode further comprises a passivation layer on the transparent conductive layer, the passivation layer covering the first electrode and the second electrode.

**7.** The light emitting diode as claimed in claim 1, **characterized in that**, the material of the epitaxial layer is N-doped gallium nitride; the active layer comprises a multiple-quantum-well active layer, the material of the multiple-quantum-well active layer being indium-gallium nitride; the material of the capping layer is P-doped gallium nitride.

**8.** A fabrication method of the light emitting diode as claimed in claim 1, comprising:

providing a substrate;
forming an epitaxial layer, an active layer and a capping layer on the substrate in sequence;
forming a plurality of microlens structures on the surface of the substrate (400) away from the epitaxial layer, and forming a plurality of cams on the surfaces of microlens structures and on the surface of the substrate away from the epitaxial layer.

**9.** The fabrication method as claimed in claim 8, **characterized in that**, the step of forming a plurality of microlens structures and a plurality of cams comprises:

forming a plurality of cylindrical photoresist blocks on the surface of the substrate away from the epitaxial layer;
baking the cylindrical photoresist blocks to turn the cylindrical photoresist blocks into spherical-crown photoresists;
performing a first inductive coupled plasma etch process until the spherical -crown photoresists are completely etched so as to form a plurality of microlens structures on the surface of the substrate away from the epitaxial layer;
forming a plurality of $Al_2O_3$ particles on the surface of the substrate away from the epitaxial layer and on the surfaces of the microlens structures;
performing a second inductive coupled plasma etch process until the $Al_2O_3$ particles are completely etched so as to form a plurality of cams on the surface of the substrate away from the epitaxial layer and on the surfaces of the microlens structures.

**10.** The fabrication method as claimed in claim 9, **characterized in that**, in the first inductive coupled plasma etch process, the etching gas is a mixture of boron trichloride, helium gas and argon gas, the cavity pressure being 50mTorr~2Torr, the plate power being 200W~300W, the coil power being 300W~500W.

**11.** The fabrication method as claimed in claim 9, **characterized in that**, in the second inductive coupled plasma etch process, the etching gas is a mixture of boron trichloride, helium gas and argon gas, the cavity pressure being 50mTorr~2Torr, the plate power being 200W~300W, the coil power being 300W~500W.

**12.** The fabrication method as claimed in claim 9, **characterized in that**, the cylindrical photoresist blocks are baked under a temperature of 120°C~250°C to turn the cylindrical photoresist blocks into spherical-crown photoresists.

**13.** The fabrication method as claimed in any one of claims 8 to 12, **characterized in that**, the material of the epitaxial layer is N-doped gallium nitride; the active layer comprises a multiple-quantum-well active layer, the material of the multiple-quantum-well active layer being indium-gallium nitride; the material of the capping layer is P-doped gallium nitride.

**14.** The fabrication method as claimed in any one of claims 8 to 12, further comprising growing a gallium nitride film on the substrate to form a buffer layer before the formation of the epitaxial layer.

**15.** The fabrication method as claimed in any one of claims 8 to 12, further comprising forming a transparent conductive layer on the capping layer after the formation of the capping layer.

16. The fabrication method as claimed in claim 15, **characterized in that**, after the formation of the transparent conductive layer, further comprising:

forming a first electrode on the transparent conductive layer;
forming an opening passing through the transparent conductive layer, the capping layer and the active layer;
forming a second electrode in the opening.

17. The fabrication method as claimed in claim 16, **characterized in that**, after forming the second electrode in the opening, further comprising:

forming a passivation layer on the transparent conductive layer, the passivation layer covering the first electrode and the second electrode.

18. The fabrication method as claimed in any one of claims 8 to 12, further comprising reducing the thickness of the substrate before the formation of a plurality of microlens structures on the surface of the substrate away from the epitaxial layer.

FIG. 1

280 —

260

270

250 —
240 —
230 —
220 —
210 —

200

201

202        202

FIG. 2

| provide a substrate | S30 |

↓

| form an epitaxial layer, an active layer and a capping layer on the substrate in sequence | S31 |

↓

| form a plurality of microlens structures on the surface of the substrate away from the epitaxial layer, and form a plurality of cams on the surfaces of the microlens structures and on the surface of the substrate away from the epitaxial layer | S32 |

FIG. 3

FIG. 4A

FIG. 4B

460    470

450
440
430
420
410

400

FIG. 4C

460    470

480

450
440
430
420
410

400

FIG. 4D

460    470

480

450
440
430
420
410

400

FIG. 4E

h1 ⇕    490

400

410
420
430
440
450
480

460    470

FIG. 4F

491    491

400

410
420
430
440
450
480

460    470

FIG. 4G

401

h2

400

410
420
430
440
450
480

460    470

FIG. 4H

403          403

400

410

420

430

440

450

480

460          470

FIG. 4I

402          402

401

400

410

420

430

440

450

480

460          470

FIG. 4J

FIG. 4K

FIG. 5

# INTERNATIONAL SEARCH REPORT

| | International application No. |
|---|---|
| | PCT/CN2010/080493 |

**A. CLASSIFICATION OF SUBJECT MATTER**

See extra sheet

According to International Patent Classification (IPC) or to both national classification and IPC

**B. FIELDS SEARCHED**

Minimum documentation searched (classification system followed by classification symbols)

IPC: H01L33/-;H01L29/-

Documentation searched other than minimum documentation to the extent that such documents are included in the fields searched

Electronic data base consulted during the international search (name of data base and, where practicable, search terms used)

CNPAT,CNKI,WPI,EPODOC: LIGHT+, EMIT+, DIODE?, LED?, SUBSTRATE?, BACK+, REAR+, SURFAC+, EPITAX+, MICRO+, +LENS, BULG+, CONVEX+, SALIENT+, SADDLE?, EXTERNAL+, QUANTUM+, EFFICIEN+, PHOTORESIST+, BAK+, ETCH+, PARTICLE?

**C. DOCUMENTS CONSIDERED TO BE RELEVANT**

| Category* | Citation of document, with indication, where appropriate, of the relevant passages | Relevant to claim No. |
|---|---|---|
| Y | US2003062530A1(OKAZAKI Haruhiko et al.)03 Apr.2003(03.04.2003) description paragraphs 48-125, figs. 2A-12 | 1-8,13-18 |
| Y | CN101794856A(SONY CORP.)04 Aug.2010(04.08.2010) description paragraphs 34-47, fig. 1 | 1-8,13-18 |
| A | US2006006554A1(YOO Myung Cheol et al.)12 Jan.2006(12.01.2006) the whole document | 1-18 |
| A | US2008157110A1(HUANG Tien-Fu et al.)03 Jul.2008(03.07.2008) the whole document | 1-18 |
| A | US7023022B2(EMCORE CORPORATION)04 Apr.2006(04.04.2006) the whole document | 1-18 |

☐ Further documents are listed in the continuation of Box C.  ☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim (S) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 21 Jun.2011(21.06.2011) | **18 Aug. 2011 (18.08.2011)** |

| Name and mailing address of the ISA/CN | Authorized officer |
|---|---|
| The State Intellectual Property Office, the P.R.China 6 Xitucheng Rd., Jimen Bridge, Haidian District, Beijing, China 100088 Facsimile No. 86-10-62019451 | FANG,Yan Telephone No. (86-10)62413925 |

Form PCT/ISA /210 (second sheet) (July 2009)

# INTERNATIONAL SEARCH REPORT
## Information on patent family members

| | International application No. |
|---|---|
| | PCT/CN2010/080493 |

| Patent Documents referred in the Report | Publication Date | Patent Family | Publication Date |
|---|---|---|---|
| US2003062530A1 | 03.04.2003 | JP2000196152A | 14.07.2000 |
| | | US6495862B1 | 17.12.2002 |
| | | US6924163B2 | 02.08.2005 |
| CN101794856A | 04.08.2010 | US2010193821A1 | 05.08.2010 |
| | | JP2010177501A | 12.08.2010 |
| US2006006554A1 | 12.01.2006 | WO2006002427A2 | 05.01.2006 |
| | | EP1769539A2 | 04.04.2007 |
| | | KR20070038973A | 11.04.2007 |
| | | CN101027777A | 29.08.2007 |
| | | JP2008503900T | 07.02.2008 |
| | | TW200608606A | 01.03.2006 |
| | | US2010117096A1 | 13.05.2010 |
| | | CN101027777B | 05.05.2010 |
| US2008157110A1 | 03.07.2008 | TW200828631A | 01.07.2008 |
| US7023022B2 | 04.04.2006 | WO0241406A1 | 23.05.2002 |
| | | AU1784502A | 27.05.2002 |
| | | US2004065886A1 | 08.04.2004 |

Form PCT/ISA /210 (patent family annex) (July 2009)

**INTERNATIONAL SEARCH REPORT**

International application No.

PCT/CN2010/080493

**CLASSIFICATION OF SUBJECT MATTER**

H01L33/20(2010.01) i

H01L33/58(2010.01) i

Form PCT/ISA /210 (extra sheet) (July 2009)

**EP 2 408 025 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 1858918 A